# EUROPEAN PATENT SPECIFICATION

(11) **EP 4 354 694 B1**
(45) Date of publication and mention of the grant of the patent: **04.02.2026**
(21) Application number: 22945959.9
(22) Date of filing: 20.12.2022
(51) Int. Cl.: H02J 7/00, H02J 7/34, G01R 31/382, H01M 10/44, H01M 50/509, B60L 58/19

(54) **SYSTEM AND METHOD FOR CHARGING CONTROL BETWEEN BATTERY PACKS**
SYSTEM UND VERFAHREN ZUR LADESTEUERUNG ZWISCHEN BATTERIEPACKS
SYSTÈME ET PROCÉDÉ DE COMMANDE DE CHARGE ENTRE DES BLOCS-BATTERIES

(30) Priority: 07.06.2022 KR 20220068958
(43) Date of publication of application: 17.04.2024
(73) Proprietor: LG ENERGY SOLUTION, LTD., Seoul 07335 (KR)
(72) Inventor: SONG, Kee Hoon, Daejeon 34122 (KR); KIM, Jun Suk, Daejeon 34122 (KR); AN, Hyo Seong, Daejeon 34122 (KR)
(74) Representative: Plasseraud IP
(86) International application number: PCT/KR2022/020850
(87) International publication number: WO 2023/239000

(56) References cited:
- WO-A1-2021/221219
- JP-A- 2013 240 219
- JP-A- 2020 018 092
- KR-A- 20120 128 898
- KR-A- 20120 128 898
- KR-A- 20130 133 557
- KR-A- 20210 133 029
- KR-A- 20220 027 630

## Description

### TECHNICAL FIELD

The present invention relates to a battery pack-to-pack charging control system and a method thereof, and more particularly, to a series battery pack-to-pack charging control system capable of reducing a state of charge (SOC) difference between series battery packs connected to an external system, and a method thereof.

### BACKGROUND ART

A battery is used in various fields, including an electric scooter, electric vehicle, energy storage capacitor, etc., as well as a portable electronic device, such as a smart phone, notebook computer, and tablet PC. A field such as an electrically driven vehicle or smart grid system often requires large capacity, and thus a plurality of battery packs are used by being connected in series in order to increase output.

Generally, in a light electric vehicle (LEV), such as an electric bicycle or an electric scooter, two battery packs are configured to be used in series. In this case, when SOCs of the two battery packs are not the same, discharging is terminated when the SOC of the battery pack having a lower SOC reaches 0% during driving, and driving is terminated at that time.

Therefore, in this way, since a driving distance is calculated and the system is controlled based on the battery pack having the lower SOC, when two battery packs having a large SOC difference are used, the system is controlled based on the battery pack having the lower SOC, and thus there is a problem in that inconvenience and anxiety occur to a user due to an unexpected short driving distance.

In this regard, when reviewing Japanese unexamined patent application publication No. JP 2013-240219 A, a technical idea of performing parallel stabilization before use of the battery in order to equalize the capacity of two battery blocks connected in series has been suggested, but a technology of performing series/parallel switching according to the usage condition of the battery has not been suggested.

As prior art related to the present invention, there are the following documents:

Japanese unexamined patent application publication No. JP 2013-240219 A, KR 2012 0128898 A and WO2021/221219 A1.

### DISCLOSURE OF THE INVENTION

### TECHNICAL PROBLEM

The present invention is intended to solve the problems described above, and is configured to reduce the SOC difference between battery packs by allowing a battery pack having a higher SOC to charge a battery pack having a lower SOC when the battery packs are connected to the system and the difference in remaining capacity (SOC) between the two battery packs is large in a standby state.

### TECHNICAL SOLUTION

In order to solve the problems described above, the present invention provides in a first aspect, a series battery pack-to-pack charging control system configured to include a first battery pack, a second battery pack, and a battery connection unit, in which the battery connection unit connects the first and second battery packs in parallel and cuts off an output to an external system when the external system is in a standby state, and connects the first and second battery packs in series and outputs a series connection output thereof to the external system when the external system is in an active state. In a second aspect, there is provided a method according to claim 9.

In this case, the battery connection unit may be configured to include an input unit that receives outputs of the first and second battery packs, an output unit that outputs or blocks the outputs of the first and second battery packs input to the input unit to the external system, and a path connection unit that constitutes connection of the first and second battery packs between the input unit and the output unit.

In addition, the input unit may be configured to include a first (+) connection part connected to a (+) terminal of the first battery pack, a second (+) connection part connected to a (+) terminal of the second battery pack, a first (-) connection part connected to a (-) terminal of the first battery pack, a second (-) connection part connected to a (-) terminal of the second battery pack, and the path connection unit may be configured to include a first path connecting the first (-) connection part and the second (-) connection part, a second path connecting the first (+) connection part and the second (+) connection part, a third path connecting the second (+) connection unit and a (+) output end, a fourth path connecting the first (+) connection part and the second (-) connection part, a fifth path connecting the first (-) connection unit and a (-) output end, and first to fifth switches opening and closing the first to fifth paths, respectively.

In this case, the external system acquires and compares pack SOCs for acquiring SOC values from the respective first and second battery packs at regular intervals, and, when the SOC difference exceeds a predetermined reference pack SOC difference, outputs a parallel switching signal to connect the first and second battery packs in parallel, thereby capable of tailoring the SOCs of the two battery packs. In addition, when the pack SOC difference is within the predetermined reference SOC difference, the parallel connection of the first and second battery packs is switched to a series connection.

### ADVANTAGEOUS EFFECTS

According to an embodiment of the present invention, when the state of charge (SOC) difference between two battery packs exceeds the standard in a state where the batteries are stored in the system by being connected thereto, the battery pack having the higher SOC charges the battery pack having the lower SOC, thereby capable of reducing the SOC difference between the two battery packs. Accordingly, since the actual driving distance of the system increases, user convenience can be increased.

### BRIEF DESCRIPTION OF THE DRAWINGS

FIG. 1 is a diagram illustrating an overall configuration of a system according to an embodiment of the present invention.
FIG. 2 is a diagram illustrating an operation in which a battery pack having a higher voltage charges a battery pack having a lower voltage according to the embodiment of the present invention.
FIG. 3 is a diagram illustrating a detailed configuration of a control unit according to the embodiment of the present invention.
FIG. 4 is a diagram illustrating a series battery pack-to-pack charging control method according to an embodiment of the present invention.

### MODES FOR CARRYING OUT THE INVENTION

Hereinafter, embodiments of the present invention will be described in detail with reference to the accompanying drawings so that those of ordinary skill in the art can easily carry out the present invention. However, the present invention may be embodied in various different forms and is not limited to the embodiments described herein. In order to clearly explain the present invention in the drawings, parts irrelevant to the description are omitted, and similar reference numerals are assigned to similar parts throughout the specification.

Hereinafter, the present invention will be described in detail with reference to the drawings.
1. Series battery pack-to-pack charging control system according to the present invention

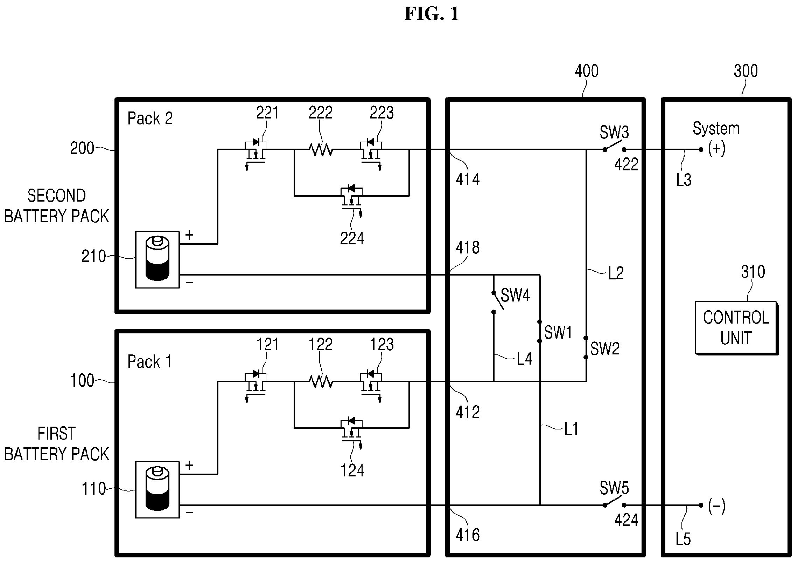

FIG. 1 is a diagram schematically illustrating the overall configuration of a series battery pack-to-pack charging control system according to an embodiment of the present invention.

Referring to FIG. 1, a system according to an embodiment of the present invention is configured to include the following configurations.

### 1. 1. Two or more battery packs

The system of the present invention includes two or more battery packs 100 and 200 connected in series with each other.

### 1. 1. 1. First battery pack 100

As illustrated in FIG. 1, the first battery pack 100 is configured to include a first battery cell module 110 and a first discharge circuit unit 120.

### a. First battery cell module 110

The first battery cell module 110 includes one or more battery cells (not illustrated), a first cell module (+) terminal, and a first battery cell module (-) terminal.

### b. First discharge circuit unit 120

The first discharge circuit unit 120 (121, 122, 123, and 124) refers to a current path configured between the first battery cell module 110 and a battery connection unit 400 to be described later. More specifically, it is formed on a path connecting the first cell module (+) terminal of the first battery cell module 110 and a first battery pack (+) terminal.

### 1) First discharge FET (D-FET) 121

The first discharge FET (D-FET) 121 is disposed in series between the first cell module (+) terminal and a first discharge resistor 122.

The first discharge FET (D-FET) 121 is turned on by a switching control unit 318 of a control unit 310 to be described later when an external system 300 connected to the first and second battery packs 100 and 200 in which the SOC of the second battery pack 200 is greater than that of the first battery pack 100 is in a standby state, that is, when a user does not use the external system 300,

### 2) First discharge resistor 122

The first discharge resistor 122 is disposed in series between the first discharge FET (D-FET) 121 and a first pre-charge FET (pre-FET) 123. The first discharge resistor 122 disposed in this way performs a function of limiting an amount of charging current flowing from the first battery pack 100 to the second battery pack 200 when a voltage of the first battery pack 100 is higher than that of the second battery pack 200.

### 3) First precharge FET (P-FET) 123

The first precharge FET (P-FET) 123 is disposed in series with the first discharge resistor 122 and the first cell module (+) terminal.

### 4) First charge FET (C-FET) 124

The first charge D-FET 124 is disposed in series between an output of the first discharge FET (D-FET) 121 and the first cell module (+) terminal, and is disposed in parallel to a series connection of the first discharge resistor 122 and the first discharge precharge FET (P-FET) 123.

### 1. 1. 2. Second battery pack 200

As illustrated in FIG. 1, the second battery pack 200 includes a second battery cell module 210 and a second discharge circuit unit 220.

### a. Second battery cell module 210

The second battery cell module 210 includes one or more battery cells (not illustrated), a second cell module (+) terminal, and a second battery cell module (-) terminal.

### b. Second discharge circuit unit 220

The second discharge circuit unit 220 (221, 222, 223, and 224) refer to a current path configured between the second battery cell module 210 and the battery connection unit 400 to be described later. More specifically, it is formed on a path connecting the second cell module (+) terminal of the second battery cell module 210 and a second battery pack (+) terminal.

### 1) Second discharge FET (D-FET) 221

The second discharge D-FET 221 is disposed in series between the first cell module (+) terminal and the first discharge resistor 222.

The second discharge FET (D-FET) 221 is turned on by the switching control unit 318 of the control unit 310 to be described later when the external system 300 connected to the first and second battery packs 100 and 200 in which the SOC of the first battery pack 100 is greater than that of the second battery pack 200 is in a standby state, that is, when the user does not use the external system 300.

### 2) Second discharge resistor 222

The second discharge resistor 222 is disposed in series between the second discharge D-FET 221 and the second discharge precharge FET (p-FET) 123. The second discharge resistor 222 disposed in this way performs a function of limiting an amount of charging current flowing from the second battery pack 200 to the first battery pack 100 when the voltage of the second battery pack 200 is higher than that of the first battery pack 100.

### 3) Second discharge precharge FET (P-FET) 223

The second discharge P-FET 223 is disposed in series with the second discharge resistor 222 and the second cell module (+) terminal.

### 4) Second charge FET (C-FET) 224

The second charge FET (C-FET) 124 is disposed in series between an output of the second discharge FET 121 and the second cell module (+) terminal, and is disposed in parallel to the series connection of the second discharge resistor 222 and the second discharge P-FET 223.

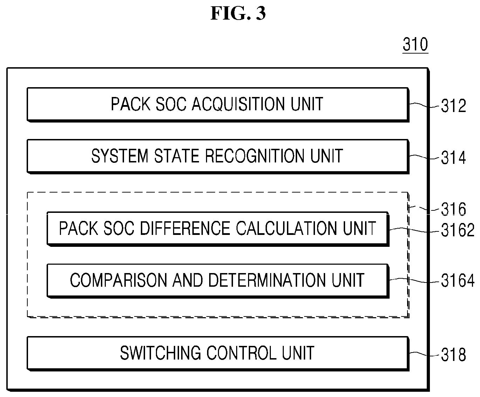

FIG. 3 is a diagram illustrating a detailed configuration of a control unit according to an embodiment of the present invention.

### 1. 2. Control unit 310

The controller 310 is a configuration that controls charging between the first and second battery packs 100 and 200 according to a SOC difference between the first and second battery packs 100 and 200 in the standby state of the external system 300 connected to the first and second battery packs 100 and 200.

### a. Pack SOC acquisition unit 312

The pack SOC acquisition unit 312 is a configuration that acquires SOC values from the respective first and second battery packs 100 and 200 at regular intervals. For acquisition or calculation of SOC, a known SOC calculation method is used.

### b. System state recognition unit 314

The system state recognition unit 314 is a configuration that recognizes whether the external system 300 is in a standby state or an active state in a state of being connected to the first and second battery packs 100 and 200.

Here, the standby state refers to a state where the user does not use the external system 300 in a state where the first and second battery packs 100 and 200 and the external system 300 are connected.

On the other hand, the active state refers to a situation in which the user uses the external system 300 in the state where the first and second battery packs 100 and 200 are connected to the external system 300.

When it is recognized as being in the standby state, for example, a standby state signal can be output.

When it is recognized as being in the active state, for example, an active state signal can be output.

### c. Whether-to-switch-connection determination unit 316

The whether-to-switch-connection determination unit 316 is a configuration that determines whether to switch a connection state between the battery packs according to the SOC difference between the first and second battery packs 100 and 200 when the standby state signal is output from the system state recognition unit 314.

The whether-to-switch-connection determination unit 316 may include the following detailed configurations.

### 1) Pack SOC difference calculation unit 3162

The pack SOC difference calculation unit 3162 calculates a pack SOC difference, which is an SOC difference value between the first and second battery packs 100 and 200, using the SOC values of the respective first and second battery packs 100 and 200 acquired by the pack SOC acquisition unit 312.

### 2) Comparison and determination unit 3164

The comparison and determination unit 3164 compares whether the calculated pack SOC difference exceeds a predetermined reference pack SOC difference, and when it exceeds the predetermined reference pack SOC difference, determines that the connection state of the first and second battery packs 100 and 200 is switched to parallel connection. In the case of the determination, for example, a parallel switching signal indicating this may be output.

In addition, the comparison and determination unit 3164 determines that the connection state of the first and second battery packs 100 and 200 is switched to series connection when the pack SOC difference calculated by the pack SOC difference calculation unit 3162 is within a predetermined reference SOC difference after the parallel switching signal is output. In this case, a signal indicating this, for example, a serial switching signal may be output.

### d. Switching control unit 318

The switching control unit 318 is a configuration that controls opening and closing of first to fifth switches SW1 to SW5 configured in the battery connection unit 400 to be described later.

Specifically, when the parallel switching signal is output from the whether-to-switch-connection determination unit 316, it turns off the third, fourth, and fifth switches SW3, SW4, and SW5 to open third, fourth, and fifth paths L3, L4, L5 and turns on the first and second switches SW1 and SW2 to close first and second paths L1 and L2, thereby connecting the first and second battery packs 100 and 200 to each other.

Accordingly, the output to the external system 300 may be cut off, and the battery pack having the higher SOC among the first and second battery packs 100 and 200 may be allowed to charge the battery pack having the lower SOC.

On the other hand, when the serial switching signal is output from the whether-to-switch-connection determination unit 316 or an active signal is output from the system state recognition unit 314, it turns on the third, fourth, and fifth switches SW3, SW4, and SW5 to close the third, fourth, and fifth paths L3, L4, and L5, and turns off first and second switches SW1 and SW2 to open the first and second paths L1 and L2, thereby connecting the first and second battery packs 100 and 200 in series with each other. Accordingly, the series connection output of the first and second battery packs 100 and 200 is supplied to the external system 300.

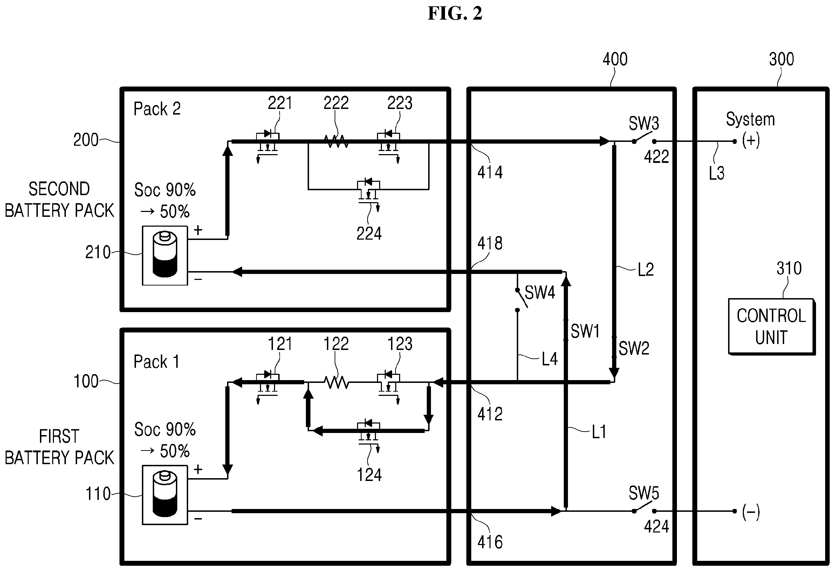

FIG. 2 is a diagram illustrating an operation in which a battery pack having a higher SOC charges a battery pack having a lower SOC according to an embodiment of the present invention.

Referring to FIG. 2, for example, when the SOC difference between the first and second battery packs 100 and 200 exceeds the predetermined reference SOC difference and the SOC of the second battery pack 200 is higher than that of the first battery pack 100, the third, fourth, and fifth switches SW3, SW4, and SW5 are turned off to open the third, fourth, and fifth paths L3, L4, and L5, and the first and second switches SW1 and SW2 are turned on to close the first and second paths L1 and L2, thereby connecting the first and second battery packs 100 and 200 in parallel to each other.

In addition, the second charge FET (C-FET) 224 is turned off, the second discharge FET (D-FET) 221 and the second discharge P-FET 223 are turned on, and the first charge FET 124 is turned on to allow the current of the second battery cell module 210 to flow into the first battery cell module 110 to charge it, thereby capable of eliminating the SOC difference between the battery packs 100 and 200.

In contrast, when the SOC of the second battery pack 200 is lower than the SOC of the first battery pack 100, in the same manner, the first and second battery packs are connected in parallel, the first discharge D-FET 121 is turned on, and the first discharge P-FET 123 of the first battery pack and the second charge FET 224 of the second battery pack are turned on to allow the current of the first battery cell module 110 to flow into the second battery cell module 210 to charge it, thereby capable of eliminating the SOC difference between the battery packs 100 and 200.

The control unit 310 as described above may be implemented in the external system 300, and may control opening and closing of the transistors 121, 123, 124, 221, 223, and 224 by transmitting a control signal to BMS (not illustrated) of the first and second battery packs.

Here, the external system 300 refers to a LEV device including, for example, an electric bicycle, an electric scooter, etc.

### 1. 3. Battery connection unit 400

When the external system 300 connected to the first and second battery packs 100 and 200 is in the standby state, the battery connection unit 400 connects the first and second battery packs 100 and 200 in parallel according to a control signal from the control unit 310 and cuts off an output to the external system 300.

On the other hand, when the external system 300 connected to the first and second battery packs 100 and 200 is in the active state, the battery connection unit 400 connects the first and second battery packs 100 and 200 in series according to the control signal from the control unit 310 and outputs the series connection output thereof to the external system 300.

This battery connection unit 400, includes the following detailed configurations as illustrated in FIG. 1.

### a. Input unit 410

The input unit is a configuration that receives outputs of the first and second battery packs 100 and 200.
1) First (+) connection part 412
   The first (+) connection part is connected to a (+) terminal of the first battery pack 100.
2) Second (+) connection part 414
   The second (+) connection part is connected to a (+) terminal of the second battery pack 200.
3) First (-) connection part 416
   The first (-) connection part is connected to a (-) terminal of the first battery pack 100.
4) Second (-) connection part 418
   The second (-) connection part is connected to a (-) terminal of the second battery pack 200.

### b. Output unit 420

The output unit is a configuration that outputs or cuts off the output of the first and second battery packs 100 and 200, which is input to the input unit, to the external system 300.
1) (+) Output end 422
   The (+) output end connects a (+) output of the first and second battery packs 100 and 200 in series to the external system 300.
2) (-) Output end 424
   The (-) output end connects a (-) output of the first and second battery packs 100 and 200 in series to the external system 300.

### c. Path connection unit 400

The path connection unit 400 configures the connection of the first and second battery packs 100 and 200 between the input unit and the output unit, and includes the following detailed configurations.
1) First path L1
   The first path L1 is a path connecting the first (-) connection part 416 and the second (-) connection part 418, and is opened and closed by the first switch SW1.
2) Second path L2
   The second path L2 is a path connecting the first (+) connection part 412 and the second (+) connection part 414, and is opened and closed by the second switch SW2.
3) Third path (L3)
   The third path L3 is a path connecting the second (+) connection part 414 and the (+) output end 422, and is opened and closed by the third switch SW3.
4) Fourth path L4
   The fourth path L4 is a path connecting the first (+) connection part 412 and the second (-) connection part 418, and is opened and closed by the fourth switch SW4.
5) Fifth path L5
   The fifth path L5 is a path connecting the first (-) connection part 416 and the (-) output end 424, and is opened and closed by the fifth switch SW5.
6) First switch SW1
   The first switch SW1 is configured on the first path L1, and is turned on/off according to the control of the switching control unit 318 of the control unit 310 to open and close the first path L1.
7) Second switch SW2
   The second switch SW2 is configured on the second path L2, and is turned on/off according to the control of the switching control unit 318 of the control unit 310 to open and close the second path L2.
8) Third switch SW3
   The third switch SW3 is configured on the third path L3, and is turned on/off according to the control of the switching control unit 318 of the control unit 310 to open and close the third path L3.
9) Fourth switch SW4
   The fourth switch SW4 is configured on the fourth path L4, and is turned on/off according to the control of the switching control unit 318 of the control unit 310 to open and close the fourth path L4.
10) Fifth switch SW5
   The fifth switch SW5 is configured on the fifth path L5 and is turned on/off according to the control of the switching control unit 318 of the control unit 310 to open and close the fifth path L5.

### 2. Series battery pack-to-pack charging control method according to the present invention

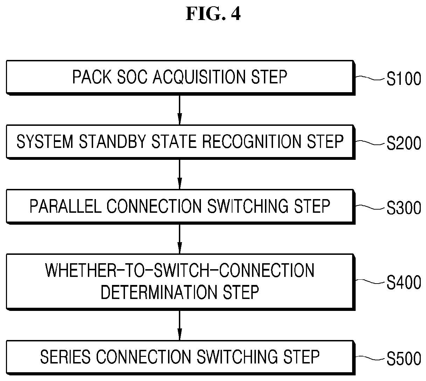

FIG. 4 is a diagram illustrating a series battery pack-to-pack charging control method according to an embodiment of the present invention.

Referring to FIG. 4, in the method according to an embodiment of the present invention, in a state where two or more battery packs connected in series are connected to/mounted in an external system (e.g., electric bicycle, electric scooter, etc.), depending on a state of the SOC difference between the battery packs and whether or not the external system is in a standby state, the SOC difference can be eliminated through serial/parallel connection switching between the battery packs. This method includes the following steps.

### 2. 1. Pack SOC acquisition step S100

The pack SOC acquisition step S100 is a step in which the control unit 310 acquires the SOC values of the respective series battery packs 100 and 200 at regular intervals.

More specifically, in the configuration of the controller 310 implemented in the external system 300 connected to the series battery packs 100 and 200, respective SOC values may be acquired at regular intervals through a communication connection with the battery packs 100 and 200.

### 2. 2. System standby state recognition step S200

The system standby state recognition step S200 is a step of recognizing whether the external system 300 is in a standby state in a state of being connected to the serial battery packs 100 and 200.

Specifically, in a state where the serial battery packs 100 and 200 and the external system 300 are connected, the control unit 310 implemented in the external system 300 can recognize whether the external system 300 is in the standby state.

Here, the standby state refers to a situation in which the external system 300 does not use the series output of the battery packs 100 and 200 in a state where the first and second battery packs 100 and 200 and the external system 300 are connected.

On the other hand, the active state is a non-standby state, and refers to a situation in which the external system 300 is driven by the series output of the battery packs 100 and 200 in a state where the first and second battery packs 100 and 200 are connected to the external system 300,

### 2. 3. Parallel connection switching step S300

The parallel connection switching step is a step of switching a connection state between the battery packs according to the SOC difference between the first and second battery packs 100 and 200 when the external system 300 is recognized as being in the standby state as a result of the recognition in the system standby state recognition step S200.

### a. First pack SOC difference calculation step

The first pack SOC difference calculation step is a step of calculating a SOC difference between the battery packs using the SOC values of the respective first and second battery packs 100 and 200 acquired in the pack SOC acquisition step S100 when the external system 300 is recognized as being in the standby state in the system standby state recognition step S200,

### b. First comparison and determination step

The first comparison and determination step is a step of comparing whether the SOC difference between the first and second battery packs 100 and 200 calculated in the first pack SOC difference calculation step exceeds a predetermined reference pack SOC difference and determining that the series connection of the battery packs 100 and 200 is switched to the parallel connection according to the comparison result.

More specifically, as a result of the comparison, when the SOC difference between the first and second battery packs 100 and 200 exceeds the predetermined reference pack SOC difference, it is determined that the series connection of the battery packs 100 and 200 is switched to the parallel connection, and the connection thereof is switched to the parallel connection.

That is, when the parallel connection switching determination is made in the first comparison and determination step, the parallel connection switching is performed.

Referring to FIG. 1, this may be implemented in a form of connecting the first and second battery packs 100 and 200 in parallel to each other by turning off the third, fourth, and fifth switches SW3, SW4, and SW5 of the battery connection unit 400 configured between the first and second battery packs 100 and 200 and the external system 300 to open the third, fourth, and fifth paths L3, L4, and L5 and turning on the first and second switches SW1 and SW2 to close the first and second paths L1 and L2.

Through these steps, the first and second battery packs 100 and 200 are connected in parallel, and thus, as illustrated in FIG. 2 , a current is allowed to flow from a battery pack having a higher SOC to a battery pack having a lower SOC among the first and second battery packs 100 and 200 to charge the battery pack, so that the SOC difference between the battery packs can be eliminated.

### 2. 4. Whether-to-switch-connection determination step S400

The whether-to-switch-connection determination step S400 is a step of determining that the parallel connection of the first and second battery packs is switched to the series connection according to whether the SOC difference between the first and second battery packs 100 and 200 is within the predetermined reference pack SOC difference after the parallel connection switching in the parallel connection switching step S300.

### a. Second pack SOC difference calculation step

The second pack SOC difference calculation step is a step of calculating the pack SOC difference using the SOC values of the respective first and second battery packs 100 acquired through the pack SOC acquisition step S100 after the first and second battery packs 100 and 200 are connected in parallel in the parallel connection switching step S300.

### b. Second comparison and determination step

The second comparison and determination step is a step of comparing whether the SOC difference between the first and second battery packs 100 and 200 calculated in the first pack SOC difference calculation step is within the predetermined reference pack SOC difference and determining that the parallel connection of the battery packs 100 and 200 is switched to the series connection when it is within the predetermined reference pack SOC difference.

### 2. 5. Series connection switching step S500

The series connection switching step S500 is a step of switching the parallel connection of the first and second battery packs 100 and 200 to the series connection when it is determined, in the whether-to-switch-connection determination step S400, that the parallel connection of the first and second battery packs 100 and 200 is switched to the series connection.

Referring to FIG. 1, this may be implemented in a form of connecting the first and second battery packs 100 and 200 in series with each other by turning on the third, fourth, and fifth switches SW3, SW4, and SW5 of the battery connection unit 400 configured between the first and second battery packs 100 and 200 and the external system 300 to close the third, fourth, and fifth paths L3, L4, and L5 and turning off the first and second switches SW1 and SW2 to open the first and second paths L1 and L2.

As such, when the SOC difference between the series battery packs 100 and 200 is large in a state where the battery packs 100 and 200 are stored in the external system 300 by being connected thereto, the SOC difference between the battery packs can be eliminated by connecting the battery packs in parallel to each other through control of the switches configured between the battery packs and the external system 300 to allow the battery pack having a higher SOC to charge the battery pack having a lower SOC. Accordingly, the usability and efficiency of the external system 300 may be improved by maximizing the time available for serial output of the first and second battery packs 100 and 200.

Meanwhile, although the technical idea of the present invention has been described in detail according to the above embodiments, it should be noted that the above embodiments are for description and not for limitation. In addition, those skilled in the art will understand that various embodiments are possible within the scope of the technical spirit of the present invention.

The reference numerals used in the present invention are as follows.
100, 200: First and second battery pack
120, 220: First and second discharge circuit unit
121, 221: First and second discharge FET
122, 222: First and second discharge resistor
123, 223: First and second discharge precharge P-FET
124, 224: First and second charge FET
300: External system
310: Control unit
312: Pack SOC acquisition unit
314: System state recognition unit
316: Whether-to-switch-connection determination unit
3162: Pack SOC difference calculation unit
3164: Comparison and determination unit
318: Switching control unit
400: Battery connection unit

## Claims

1. A battery pack-to-pack charging control system comprising:
a first battery pack (100);
a second battery pack (200); and
a battery connection unit (400), wherein
the battery connection unit (400):
is configured to connect the first and second battery packs in parallel and cuts off an output to an external system (300) when the external system (300) is in a standby state, and
is configured to connect the first and second battery packs in series and outputs a series connection output thereof to the external system (300) when the external system (300) is in an active state.

2. The system of claim 1, wherein
the battery connection unit (400) is configured to comprise
an input unit (410) that is configured to receive outputs of the first and second battery packs,
an output unit (420) that is configured to output or block the outputs of the first and second battery packs input to the input unit (410) to the external system (300), and
a path connection unit that constitutes connection of the first and second battery packs between the input unit (410) and the output unit (420).

3. The system of claim 2, wherein
the input unit (410) is configured to comprise
a first + connection part (412) connected to a + terminal of the first battery pack (100),
a second + connection part (414) connected to a + terminal of the second battery pack (200),
a first - connection part (416) connected to a - terminal of the first battery pack (100),
a second - connection part (418) connected to a - terminal of the second battery pack (200), and
the path connection unit is configured to comprise
a first path connecting the first - connection part (416) and the second - connection part (418),
a second path connecting the first + connection part (412) and the second + connection part (414),
a third path connecting the second + connection unit (414) and a + output end (422),
a fourth path connecting the first + connection part (416) and the second - connection part (418),
a fifth path connecting the first - connection unit (416) and a - output end (424), and
first to fifth switches opening and closing the first to fifth paths, respectively.

4. The system of claim 3, wherein
the first and second battery packs respectively comprise:
first (120) and second (220) discharge circuit units in a path connecting a + terminal of a cell module and a pack + terminal, and
the first and second discharge circuit units are configured to respectively comprise
a discharge FET (121, 221), a discharge resistor (122, 222) and a discharge precharge FET (123, 223) connected in series to the discharge FET (121, 221); and
a charge FET (124, 224) connected in parallel to the resistor (122, 222) and the discharge precharge FET (123, 223) connected in series to the discharge FET (121, 221).

5. The system of claim 4, wherein
the external system (300) comprises a control unit (310),
the control unit (310) comprises
a pack SOC acquisition unit (312) configured to acquire SOC values from the respective first and second battery packs at regular intervals,
a system state recognition unit (314) configured to recognize whether the external system (300) is in a standby state, and outputs a standby state signal when it is recognized as being in the standby state,
a whether-to-switch-connection determination unit (316) configured to determine whether to switch a connection state between the battery packs according to a SOC difference between the first and second battery packs when the standby state signal is output from the system state recognition unit (314), and
a switching control unit (318) configured to control opening and closing of the first to fifth switches.

6. The system of claim 5, wherein
the whether-to-switch-connection determination unit (316) is configured to comprise:
a pack SOC difference calculation unit (3162) configured to calculate a pack SOC difference using the SOC values of the respective first and second battery packs acquired by the pack SOC acquisition unit, when the standby state signal is output, and
a comparison and determination unit (3164) configured to compare whether the calculated pack SOC difference exceeds a predetermined reference pack SOC difference, and determine that the first and second battery packs are switched to a parallel connection when the difference exceeds the predetermined reference pack SOC difference, and
output a parallel switching signal when the comparison and determination unit (3164) determines that the parallel connection switching is to be made.

7. The system of claim 6, wherein
the switching control unit (318)
when the parallel switching signal is output, is configured to turn off the third, fourth, and fifth switches to open the third, fourth, and fifth paths, and turn on the first and second switches to close the first and second paths to connect the first and second battery packs in parallel.

8. The system of claim 7, wherein
the comparison and determination unit (3164)
when the pack SOC difference calculated by the pack SOC difference calculation unit (3162) is within the predetermined reference pack SOC difference after the parallel switching signal is output, is configured to determine that the first and second battery packs are switched to be connected in series and outputs a serial switching signal, and
the switching control unit (318)
when the serial switching signal is output, is configured to turn on the third, fourth, and fifth switches to close the third, fourth, and fifth paths, and turns off the first and second switches to open the first and second paths, thereby connecting the first and second battery packs in series.

9. A battery pack-to-pack charging control method for controlling charging between battery packs, the method comprising:
a system standby state recognition step (S200) of recognizing whether an external system (300) is in a standby state;
a parallel connection switching step (S300) of connecting first (100) and second (200) battery packs in parallel and cutting off an output to the external system (300) when the external system (300) is recognized as being in the standby state; and
a step of connecting (S500) the first and second battery packs in series and outputting a series connection output thereof to the external system when the external system (300) is in an active state.

10. The method of claim 9, further comprising:
a pack SOC acquisition step (S100) of acquiring SOC values of respective first and second battery packs at regular intervals in the external system (300);
wherein
the parallel connection switching step (S300) further comprises
a first pack SOC difference calculation step of calculating a pack SOC difference using the SOC values of the respective first and second battery packs acquired in the pack SOC acquisition step when the external system is recognized as being in the standby state, and
a first comparison and determination step of comparing whether the calculated pack SOC difference exceeds a predetermined reference pack SOC difference, and determining that the first and second battery packs are switched to a parallel connection when the difference exceeds the predetermined reference pack SOC difference.

11. The method of claim 10, wherein
in the parallel connection switching step (S300),
a third, fourth, and fifth switches of a battery connection unit (400) configured between the first and second battery packs and the external system are turned off to open a third, fourth, and fifth paths, and a first and second switches are turned on to close a first and second paths, thereby connecting the first and second battery packs in parallel.

12. The method of claim 10, further comprising:
a whether-to-switch-connection determination step (S400) of determining whether the parallel connection of the first and second battery packs is switched to a series connection according to whether the SOC difference between the first and second battery packs is within the predetermined reference pack SOC difference after the parallel connection switching step; and
a series connection switching step (S500) of connecting the first and second battery packs in series when it is determined, in the whether-to-switch-connection determination step (S400), that the parallel connection is to be switched to the series connection, wherein
the whether-to-switch-connection determination step (S400) comprises
a second pack SOC difference calculation step of calculating the pack SOC difference using the SOC values of the respective first and second battery packs acquired in the pack SOC acquisition step after the parallel connection, and
a second comparison and determination step of determining that the parallel connection of the first and second battery packs is to be switched to the series connection when the calculated pack SOC difference is within the predetermined reference SOC difference.

13. The method of claim 12, wherein
in the series connection switching step (S500),
the third, fourth, and fifth switches of the battery connection unit (400) configured between the first and second battery packs and the external system are turned on to close the third, fourth, and fifth paths and the first and second switches are turned off to open the first and second paths to connect the first and second battery packs in series.

## Patentansprüche

1. Batterie-Pack-zu-Pack-Ladesteuerungssystem, umfassend:
einen ersten Batteriepack (100);
einen zweiten Batteriepack (200); und
eine Batterieverbindungseinheit (400), wobei
die Batterieverbindungseinheit (400):
dazu eingerichtet ist, den ersten und den zweiten Batteriepack parallelzuschalten, und einen Ausgang an ein externes System (300) unterbricht, wenn sich das externe System (300) in einem Ruhezustand befindet, und
dazu eingerichtet ist, den ersten und den zweiten Batteriepack in Reihe zu schalten, und einen Reihenschaltungsausgang davon an das externe System (300) ausgibt, wenn sich das externe System (300) in einem aktiven Zustand befindet.

2. System nach Anspruch 1, wobei
die Batterieverbindungseinheit (400) derart eingerichtet ist, dass sie umfasst:
eine Eingangseinheit (410), welche dazu eingerichtet ist, Ausgänge des ersten und des zweiten Batteriepacks zu empfangen,
eine Ausgangseinheit (420), welche dazu eingerichtet ist, die in die Eingangseinheit (410) eingegebenen Ausgänge des ersten und des zweiten Batteriepacks an das externe System (300) auszugeben oder zu blockieren, und
eine Pfadverbindungseinheit, welche eine Verbindung des ersten und des zweiten Batteriepacks zwischen der Eingangseinheit (410) und der Ausgangseinheit (420) bildet.

3. System nach Anspruch 2, wobei
die Eingangseinheit (410) derart eingerichtet ist, dass sie umfasst:
einen ersten (+)-Verbindungsteil (412), welcher mit einem (+)-Anschluss des ersten Batteriepacks (100) verbunden ist,
einen zweiten (+)-Verbindungsteil (414), welcher mit einem (+)-Anschluss des zweiten Batteriepacks (200) verbunden ist,
einen ersten (-)-Verbindungsteil (416), welcher mit einem (-)-Anschluss des ersten Batteriepacks (100) verbunden ist,
einen zweiten (-)-Verbindungsteil (418), welcher mit einem (-)-Anschluss des zweiten Batteriepacks (200) verbunden ist, und
die Pfadverbindungseinheit derart eingerichtet ist, dass sie umfasst:
einen ersten Pfad, welcher den ersten (-)-Verbindungsteil (416) und den zweiten (-)-Verbindungsteil (418) verbindet,
einen zweiten Pfad, welcher den ersten (+)-Verbindungsteil (412) und den zweiten (+)-Verbindungsteil (414) verbindet,
einen dritten Pfad, welcher die zweite (+)-Verbindungseinheit (414) und ein (+)-Ausgangsende (422) verbindet,
einen vierten Pfad, welcher den ersten (+)-Verbindungsteil (416) und den zweiten (-)-Verbindungsteil (418) verbindet,
einen fünften Pfad, welcher die erste (-)-Verbindungseinheit (416) und ein (-)-Ausgangsende (424) verbindet, und
einen ersten bis einen fünften Schalter, welche den ersten bis fünften Pfad öffnen bzw. schließen.

4. System nach Anspruch 3, wobei
der erste bzw. der zweite Batteriepack umfassen:
eine erste (120) und eine zweite (220) Entladeschaltungseinheit in einem Pfad, welcher einen (+)-Anschluss eines Zellmoduls und einen Pack-(+)-Anschluss verbindet, und
die erste und die zweite Entladeschaltungseinheit derart eingerichtet sind, dass sie jeweils umfassen:
einen Entlade-FET (121, 221), einen Entladewiderstand (122, 222) und eine Entlade-Vorlade-FET (123, 223), welcher in Reihe mit dem Entlade-FET (121, 221) geschaltet ist; und
einen Lade-FET (124, 224), welcher parallel zu dem Widerstand (122, 222) und dem Entlade-Vorlade-FET (123, 223) geschaltet ist, welcher in Reihe mit dem Entlade-FET (121, 221) geschaltet ist.

5. System nach Anspruch 4, wobei
das externe System (300) eine Steuereinheit (310) umfasst und
die Steuereinheit (310) umfasst:
eine Pack-SOC-Erfassungseinheit (312), welche dazu eingerichtet ist, SOC-Werte von dem ersten bzw. dem zweiten Batteriepack in regelmäßigen Intervallen zu erfassen,
eine Systemzustand-Erkennungseinheit (314), welche dazu eingerichtet ist, zu erkenne, ob sich das externe System (300) in einem Ruhezustand befindet, und ein Ruhezustandssignal ausgibt, wenn erkannt wird, dass es sich in dem Ruhezustand befindet,
eine Einheit (316) zur Bestimmung, ob die Schaltung umgeschaltet werden soll, welche dazu eingerichtet ist, gemäß einer SOC-Differenz zwischen dem ersten und dem zweiten Batteriepack zu bestimmen, ob ein Schaltungszustand zwischen den Batteriepacks umgeschaltet werden soll, wenn das Ruhezustandssignal von der Systemzustand-Erkennungseinheit (314) ausgegeben wird, und
eine Umschaltsteuereinheit (318), welche dazu eingerichtet ist, ein Öffnen und ein Schließen des ersten bis fünften Schalters zu steuern.

6. System nach Anspruch 5, wobei
die Einheit (316) zur Bestimmung, ob die Schaltung umgeschaltet werden soll, derart eingerichtet ist, dass sie umfasst:
eine Pack-SOC-Differenz-Berechnungseinheit (3162), welche dazu eingerichtet ist, unter Verwendung der durch die Pack-SOC-Erfassungseinheit erfassten SOC-Werte des ersten bzw. des zweiten Batteriepacks eine Pack-SOC-Differenz zu berechnen, wenn das Ruhezustandssignal ausgegeben wird, und
eine Vergleichs- und Bestimmungseinheit (3164), welche dazu eingerichtet ist, zu vergleichen, ob die berechnete Pack-SOC-Differenz eine vorbestimmte Referenzpack-SOC-Differenz überschreitet, und zu bestimmen, dass der erste und der zweite Batteriepack auf eine Parallelschaltung umgeschaltet sind, wenn die Differenz die vorbestimmte Referenzpack-SOC-Differenz überschreitet, und
ein Parallelumschaltsignal auszugeben, wenn die Vergleichs- und Bestimmungseinheit (3164) bestimmt, dass das Umschalten in die Parallelschaltung ausgeführt werden soll.

7. System nach Anspruch 6, wobei
die Umschaltsteuereinheit (318),
wenn das Parallelumschaltsignal ausgegeben wird, dazu eingerichtet ist, den dritten, den vierten und den fünften Schalter auszuschalten, um den dritten, den vierten und den fünften Pfad zu öffnen, und den ersten und den zweiten Schalter einzuschalten, um den ersten und den zweiten Pfad zu schließen, um den ersten und den zweiten Batteriepack parallelzuschalten.

8. System nach Anspruch 7, wobei
die Vergleichs- und Bestimmungseinheit (3164),
wenn die durch die Pack-SOC-Differenz-Berechnungseinheit (3162) berechnete SOC-Differenz innerhalb der vorbestimmten Referenzpack-SOC-Differenz liegt, nachdem das Parallelumschaltsignal ausgegeben worden ist, dazu eingerichtet ist, zu bestimmen, dass der erste und der zweite Batteriepack derart umgeschaltet werden, dass sie in Reihe geschaltet sind, und ein Reihenumschaltsignal ausgibt, und
die Umschaltsteuereinheit (318),
wenn das Reihenumschaltsignal ausgegeben wird, dazu eingerichtet ist, den dritten, den vierten und den fünften Schalter einzuschalten, um den dritten, den vierten und den fünften Pfad zu schließen, und den ersten und den zweiten Schalter ausschaltet, um den ersten und den zweiten Pfad zu öffnen, wodurch der erste und der zweite Batteriepack in Reihe geschaltet werden.

9. Batterie-Pack-zu-Pack-Ladesteuerungsverfahren zum Steuern eines Ladens zwischen Batteriepacks, wobei das Verfahren umfasst:
einen System-Ruhezustand-Erkennungsschritt (S200) eines Erkennens, ob sich ein externes System (300) in einem Ruhezustand befindet;
einen Parallelschaltung-Umschaltschritt (S300) eines Parallelschaltens eines ersten (100) und eines zweiten (200) Batteriepacks und eines Unterbrechens eines Ausgangs an das externe System (300), wenn erkannt wird, dass sich das externe System (300) in dem Ruhezustand befindet; und
einen Schritt eines Schaltens (S500) des ersten und des zweiten Batteriepacks in Reihe und eines Ausgebens eines Reihenschaltungsausgangs davon an das externe System, wenn sich das externe System (300) in einem aktiven Zustand befindet.

10. Verfahren nach Anspruch 9, ferner umfassend:
einen Pack-SOC-Erfassungsschritt (S100) eines Erfassens von SOC-Werten eines ersten bzw. eines zweiten Batteriepacks in regelmäßigen Intervallen in dem externen System (300);
wobei
der Parallelschaltung-Umschaltschritt (S300) ferner umfasst:
einen ersten Pack-SOC-Differenz-Berechnungsschritt eines Berechnens einer Pack-SOC-Differenz unter Verwendung der in dem Pack-SOC-Erfassungsschritt erfassten SOC-Werte des ersten bzw. des zweiten Batteriepacks, wenn erkannt wird, dass sich das externe System in dem Ruhezustand befindet, und
einen ersten Vergleichs- und Bestimmungsschritt eines Vergleichens, ob die berechnete Pack-SOC-Differenz eine vorbestimmte Referenzpack-SOC-Differenz überschreitet, und eines Bestimmens, dass der erste und der zweite Batteriepack auf eine Parallelschaltung umgeschaltet sind, wenn die Differenz die vorbestimmte Referenzpack-SOC-Differenz überschreitet.

11. Verfahren nach Anspruch 10, wobei
in dem Parallelschaltung-Umschaltschritt (S300),
ein dritter, ein vierter und ein fünfter Schalter einer Batterieverbindungseinheit (400), welche zwischen dem ersten und dem zweiten Batteriepack und dem externen System eingerichtet ist, ausgeschaltet werden, um einen dritten, einen vierten und einen fünften Pfad zu öffnen, und ein erster und ein zweiter Schalter eingeschaltet werden, um einen ersten und einen zweiten Pfad zu schließen, wodurch der erste und der zweite Batteriepack parallelgeschaltet werden.

12. Verfahren nach Anspruch 10, ferner umfassend:
einen Bestimmungsschritt (S400), ob die Schaltung umgeschaltet werden soll, eines Bestimmens, ob die Parallelschaltung des ersten und des zweiten Batteriepacks in eine Reihenschaltung umgeschaltet wird, je nachdem, ob die SOC-Differenz nach dem Parallelschaltung-Umschaltschritt zwischen dem ersten und dem zweiten Batteriepack innerhalb der vorbestimmten Referenzpack-SOC-Differenz liegt; und
einen Reihenschaltung-Umschaltschritt (S500) eines in Reihe Schaltens des ersten und des zweiten Batteriepacks, wenn in dem Bestimmungsschritt (S400), ob die Schaltung umgeschaltet werden soll, bestimmt wird, dass die Parallelschaltung auf die Reihenschaltung umgeschaltet werden soll, wobei
der Bestimmungsschritt (S400), ob die Schaltung umgeschaltet werden soll,
umfasst:
einen zweiten Pack-SOC-Differenz-Berechnungsschritt eines Berechnens der Pack-SOC-Differenz unter Verwendung der in dem Pack-SOC-Erfassungsschritt nach der Parallelschaltung erfassten SOC-Werte des ersten bzw. des zweiten Batteriepacks und
einen zweiten Vergleichs- und Bestimmungsschritt eines Bestimmens, dass die Parallelschaltung des ersten und des zweiten Batteriepacks auf die Reihenschaltung umgeschaltet werden soll, wenn die berechnete Pack-SOC-Differenz innerhalb der vorbestimmten Referenz-SOC-Differenz liegt.

13. Verfahren nach Anspruch 12, wobei
in dem Reihenschaltung-Umschaltschritt (S500),
der dritte, der vierte und der fünfte Schalter der Batterieverbindungseinheit (400), welche zwischen dem ersten und dem zweiten Batteriepack und dem externen System eingerichtet ist, eingeschaltet werden, um den dritten, den vierten und den fünften Pfad zu schließen, und der erste und der zweite Schalter ausgeschaltet werden, um den ersten und den zweiten Pfad zu öffnen, um den ersten und den zweiten Batteriepack in Reihe zu schalten.

## Revendications

1. Système de commande de charge entre blocs-batteries comprenant :
un premier bloc-batterie (100) ;
un second bloc-batterie (200) ; et
une unité de connexion de batteries (400), dans lequel
l'unité de connexion de batteries (400) : est configurée pour connecter les premier et second blocs-batteries en parallèle et coupe une sortie vers un système externe (300) lorsque le système externe (300) est dans un état de veille, et est configurée pour connecter les premier et second blocs-batteries en série et délivre en sortie une sortie de connexion série de ceux-ci au système externe (300) lorsque le système externe (300) est dans un état actif.

2. Système selon la revendication 1, dans lequel
l'unité de connexion de batteries (400) est configurée pour comprendre une unité d'entrée (410) qui est configurée pour recevoir des sorties des premier et second blocs-batteries,
une unité de sortie (420) qui est configurée pour délivrer en sortie ou bloquer les sorties des premier et second blocs-batteries entrées dans l'unité d'entrée (410) vers le système externe (300), et
une unité de connexion de trajets qui constitue une connexion des premier et second blocs-batteries entre l'unité d'entrée (410) et l'unité de sortie (420).

3. Système selon la revendication 2, dans lequel
l'unité d'entrée (410) est configurée pour comprendre
une première pièce de connexion + (412) connectée à une borne + du premier bloc-batterie (100),
une seconde pièce de connexion + (414) connectée à une borne + du second bloc-batterie (200),
une première pièce de connexion - (416) connectée à une borne - du premier bloc-batterie (100),
une seconde pièce de connexion - (418) connectée à une borne - du second bloc-batterie (200), et
l'unité de connexion de trajets est configurée pour comprendre
un premier trajet connectant la première pièce de connexion - (416) et la seconde pièce de connexion - (418),
un deuxième trajet connectant la première pièce de connexion + (412) et la seconde pièce de connexion + (414),
un troisième trajet connectant la seconde unité de connexion + (414) et une extrémité de sortie + (422),
un quatrième trajet connectant la première pièce de connexion + (416) et la seconde pièce de connexion - (418),
un cinquième trajet connectant la première unité de connexion - (416) et une extrémité de sortie - (424), et
des premier à cinquième commutateurs ouvrant et fermant respectivement les premier à cinquième trajets.

4. Système selon la revendication 3, dans lequel
les premier et second blocs-batteries comprennent respectivement :
des première (120) et seconde (220) unités de circuit de décharge dans un trajet connectant une borne + d'un module de cellules et une borne + de bloc, et
les première et seconde unités de circuit de décharge sont configurées pour comprendre respectivement un FET de décharge (121, 221), une résistance de décharge (122, 222) et un FET de pré-charge de décharge (123, 223) connectés en série au FET de décharge (121, 221) ; et
un FET de charge (124, 224) connecté en parallèle à la résistance (122, 222) et au FET de pré-charge de décharge (123, 223) connectés en série au FET de décharge (121, 221).

5. Système selon la revendication 4, dans lequel
le système externe (300) comprend une unité de commande (310),
l'unité de commande (310) comprend
une unité d'acquisition d'état de charge (SOC) de blocs (312) configurée pour acquérir des valeurs de SOC à partir des premier et second blocs-batteries respectifs à des intervalles réguliers,
une unité de reconnaissance d'état système (314) configurée pour reconnaitre si le système externe (300) est dans un état de veille, et qui délivre en sortie un signal d'état de veille lorsqu'il est reconnu qu'il se trouve dans l'état de veille,
une unité de détermination de convenance de commutation de connexion (316) configurée pour déterminer s'il convient de commuter un état de connexion entre les blocs-batteries en fonction d'une différence de SOC entre les premier et second blocs-batteries lorsque le signal d'état de veille est délivré en sortie par l'unité de reconnaissance d'état système (314), et
une unité de commande de commutation (318) configurée pour commander l'ouverture et la fermeture des premier à cinquième commutateurs.

6. Système selon la revendication 5, dans lequel
l'unité de détermination de convenance de commutation de connexion (316) est configurée pour comprendre :
une unité de calcul de différence de SOC de blocs (3162) configurée pour calculer une différence de SOC de blocs à l'aide des valeurs de SOC des premier et second blocs-batteries respectifs acquises par l'unité d'acquisition de SOC de blocs, lorsque le signal d'état de veille est délivré en sortie, et
une unité de comparaison et de détermination (3164) configurée pour comparer si la différence de SOC de blocs calculée dépasse une différence de SOC de blocs de référence prédéterminée, et déterminer que les premier et second blocs-batteries sont commutés en une connexion parallèle lorsque la différence dépasse la différence de SOC de blocs de référence prédéterminée, et
délivrer en sortie un signal de commutation en parallèle lorsque l'unité de comparaison et de détermination (3164) détermine que la commutation en connexion parallèle doit être effectuée.

7. Système selon la revendication 6, dans lequel
l'unité de commande de commutation (318)
lorsque le signal de commutation en parallèle est délivré en sortie, est configurée pour bloquer les troisième, quatrième et cinquième commutateurs afin d'ouvrir les troisième, quatrième et cinquième trajets, et pour rendre les premier et deuxième commutateurs passants afin de fermer les premier et deuxième trajets, pour connecter les premier et second blocs-batteries en parallèle.

8. Système selon la revendication 7, dans lequel
l'unité de comparaison et de détermination (3164)
lorsque la différence de SOC de blocs, calculée par l'unité de calcul de différence de SOC de blocs (3162), se situe dans la différence de SOC de blocs de référence prédéterminée après la sortie du signal de commutation en parallèle, est configurée pour déterminer que les premier et second blocs-batteries sont commutés pour être connectés en série et délivre en sortie un signal de commutation en série, et
l'unité de commande de commutation (318)
lorsque le signal de commutation en série est délivré en sortie, est configurée pour rendre les troisième, quatrième et cinquième commutateurs passants afin de fermer les troisième, quatrième et cinquième trajets, et bloque les premier et deuxième commutateurs pour ouvrir les première et deuxième trajets, connectant ainsi les premier et second blocs-batteries en série.

9. Procédé de commande de charge entre blocs-batteries pour commander une charge entre des blocs-batteries, le procédé comprenant :
une étape de reconnaissance d'état de veille système (S200) consistant à reconnaitre si un système externe (300) est dans un état de veille ;
une étape de commutation en connexion parallèle (S300) consistant à connecter des premier (100) et second (200) blocs-batteries en parallèle et à couper une sortie vers le système externe (300) lorsque le système externe (300) est reconnu comme étant dans l'état de veille ; et
une étape de connexion (S500) des premier et second blocs-batteries en série et de sortie d'une sortie de connexion série de ceux-ci vers le système externe lorsque le système externe (300) est dans un état actif.

10. Procédé selon la revendication 9, comprenant en outre :
une étape d'acquisition de SOC de blocs (S100) consistant à acquérir des valeurs de SOC de premiers et second blocs-batteries respectifs à des intervalles réguliers dans le système externe (300) ;
dans lequel
l'étape de commutation en connexion parallèle (S300) comprend en outre une première étape de calcul de différence de SOC de blocs consistant à calculer une différence de SOC de blocs à l'aide des valeurs de SOC des premier et second blocs-batteries respectifs acquises lors de l'étape d'acquisition de SOC de blocs lorsque le système externe est reconnu comme étant dans l'état de veille, et
une première étape de comparaison et de détermination consistant à comparer si la différence de SOC de blocs calculée dépasse une différence de SOC de blocs de référence prédéterminée, et à déterminer que les premier et second blocs-batteries sont commutés en une connexion parallèle lorsque la différence dépasse la différence de SOC de blocs de référence prédéterminée.

11. Procédé selon la revendication 10, dans lequel
lors de l'étape de commutation en connexion parallèle (S300),
des troisième, quatrième et cinquième commutateurs d'une unité de connexion de batteries (400) configurée entre les premier et second blocs-batteries et le système externe sont bloqués pour ouvrir des troisième, quatrième et cinquième trajets, et des premier et deuxième commutateurs sont rendus passants pour fermer des premier et deuxième trajets, connectant ainsi les premier et second blocs-batteries en parallèle.

12. Procédé selon la revendication 10, comprenant en outre :
une étape de détermination de convenance de commutation de connexion (S400) consistant à déterminer si la connexion parallèle des premier et second blocs-batteries doit être commutée en une connexion série selon que la différence de SOC entre les premier et second blocs-batteries se situe dans la différence de SOC de blocs de référence prédéterminée, après l'étape de commutation en connexion parallèle ; et
une étape de commutation en connexion série (S500) consistant à connecter les premier et second blocs-batteries en série lorsqu'il est déterminé, lors de l'étape de détermination de convenance de commutation de connexion (S400), que la connexion parallèle doit être commutée en la connexion série, dans lequel
l'étape de détermination de convenance de commutation de connexion (S400) comprend
une seconde étape de calcul de différence de SOC de blocs consistant à calculer la différence de SOC de blocs à l'aide des valeurs de SOC des premier et second blocs-batteries respectifs acquises lors de l'étape d'acquisition de SOC de blocs après la connexion parallèle, et
une seconde étape de comparaison et de détermination consistant à déterminer que la connexion parallèle des premier et second blocs-batteries doit être commutée en la connexion série lorsque la différence de SOC de blocs calculée se situe dans la différence de SOC de référence prédéterminée.

13. Procédé selon la revendication 12, dans lequel
lors de l'étape de commutation en connexion série (S500),
les troisième, quatrième et cinquième commutateurs de l'unité de connexion de batteries (400) configurée entre les premier et second blocs-batteries et le système externe sont rendus passants pour fermer les troisième, quatrième et cinquième trajets et les premier et deuxième commutateurs sont bloqués pour ouvrir les premier et deuxième trajets pour connecter les premier et second blocs-batteries en série.
